# EUROPEAN PATENT APPLICATION

(11) **EP 3 671 923 A1**
(43) Date of publication of application: **24.06.2020**
(21) Application number: 18214727.2
(22) Date of filing: 20.12.2018
(51) Int. Cl.: H01M 8/04007, H01M 8/0432, H01M 8/04701, H01M 8/249, F25B 27/02, G01F 1/20, H04B 1/00, H04W 52/00, H05K 7/20

(54) **HEAT TRANSFER ARRANGEMENT**

(71) Applicant: Nokia Technologies Oy, 02610 Espoo (FI)
(72) Inventor: SCHECK, Hans-Otto, 18594 Vaxholm (SE)
(74) Representative: Whiting, Gary

(57) **Abstract**

An apparatus, method and computer program is described, comprising: determining a temperature associated with one or more of a plurality of devices of a base station of a communication system; transferring heat away from one or more active devices of the plurality that are in an active state or mode of operation using a heat transfer medium; and transferring at least some of the heat transferred away from the one or more devices of the plurality that are in the active state or mode of operation to one or more devices of the plurality that are in an inactive state or mode of operation using the heat transfer medium.

## Description

### Field

The present specification relates to arrangements for transferring heat in a communication system.

### Background

Devices that form parts of a base station of a communication system can become hot in use. Heat transfer mediums (such as liquids) can be used for cooling such devices. There remains a need for further developments for transferring heat in communication systems.

### Summary

In a first aspect, this specification describes an apparatus comprising: means for determining a temperature associated with one or more of a plurality of devices of a base station of a communication system (e.g. determined by one or more temperature sensors); means for transferring heat away from one or more devices of the plurality that are in an active state or mode of operation using a heat transfer medium (such as a heat transfer liquid); and means for transferring at least some of the heat transferred away from the one or more devices of the plurality that are in the active state or mode of operation to one or more devices of the plurality that are in an inactive state or mode of operation using the heat transfer medium.

In some embodiments, one or more (e.g. all) of said devices are telecommunication devices. For example, some or all of the devices may be radio devices at a radio site. Alternatively, or in addition, one or more of said devices may be fuel cells. Alternative embodiments may include other types of devices in addition to, or instead of, the telecommunication devices and/or fuel cells described herein.

The temperature associated with the one or more of the plurality of devices may be a temperature of the one or more of the plurality of devices respectively. Alternatively, or in addition, the temperature associated with the one or more of the plurality of devices may be a temperature of the heat transfer medium received from the one or more of the plurality of devices respectively.

Some embodiments may further comprise means for maintaining a temperature of one or more of said one or more devices above a threshold value. The threshold temperature may be a dew point (e.g. to prevent corrosion and/or short-circuits). Alternatively, the threshold maybe relatively close to a temperature that might occur or be expected when the device is active (i.e. in an active state or m ode or operation), for example to prevent significant temperature fluctuations/cycling (e.g. to improve reliability).

Some embodiments may further comprise means for maintaining a temperature of one or more of said one or more devices within a defined temperature range.

In some embodiments, there may be provided: means for mixing heat transfer medium received from the one or more devices of the plurality that are in the active state or mode of operation; and means for distributing the mixed heat transfer medium to the one or more devices of the plurality that are in the inactive state or mode of operation.

In some embodiments, there may be provided: means for mixing heat transfer medium received from one or more devices of the plurality that are in the active state or mode of operation and heat transfer medium received from one or more devices of the plurality that are in the inactive state or mode of operation; and means for distributing the mixed heat transfer medium to the one or more devices of the plurality that are in the inactive state or mode of operation.

In some embodiments, there may be provided a plurality of mixing means, each mixing means for providing heat transfer medium to one of said plurality of devices. Each mixing means may comprise: means for receiving first heat transfer medium from a first heat transfer medium source; means for receiving second heat transfer medium from a second heat transfer medium source; and means for mixing the first and second heat transfer mediums at a proportion dependent on the temperature associated with the respective first device. The first heat transfer medium source may collect heat transfer medium received from at least some of the plurality of devices. The second heat transfer medium source may distribute heat transfer medium from a heat exchanger to at least some of the plurality of devices.

The said means may comprise: at least one processor; and at least one memory including computer program code, the at least one memory and the computer program configured, with the at least one processor, to cause the performance of the apparatus.

In a second aspect, this specification describes a method comprising: determining a temperature associated with one or more of a plurality of devices of a base station of a communication system; transferring heat away from one or more devices of the plurality that are in an active state or mode of operation using a heat transfer medium; and transferring at least some of the heat transferred away from the one or more devices of the plurality that are in the active state or mode of operation to one or more devices of the plurality that are in an inactive state or mode of operation using the heat transfer medium.

The temperature associated with the one or more of the plurality of devices may be a temperature of the one or more of the plurality of devices respectively. Alternatively, or in addition, the temperature associated with the one or more of the plurality of devices may be a temperature of the heat transfer medium received from the one or more of the plurality of devices respectively.

Some embodiments may further comprise maintaining a temperature of one or more of said one or more devices above a threshold value. The threshold temperature may be a dew point (e.g. to prevent corrosion and/or short-circuits). Alternatively, the threshold may be relatively close to a temperature that might occur or be expected when the device is in the active state or mode of operation, for example to prevent significant temperature fluctuations/ cycling (e.g. to improve reliability).

Some embodiments may further comprise maintaining a temperature of one or more of said one or more devices within a defined temperature range.

Some embodiments may further comprise: mixing heat transfer medium received from the one or more devices of the plurality that are in the active state or mode of operation; and distributing the mixed heat transfer medium to the one or more devices of the plurality that are in the inactive state or mode of operation.

Some embodiments may further comprise: mixing heat transfer medium received from one or more devices of the plurality that are in the active state or mode of operation and heat transfer medium received from one or more devices of the plurality that are in the inactive state or mode of operation; and distributing the mixed heat transfer medium to the one or more devices of the plurality that are in the inactive state or mode of operation.

In some embodiments, there may be provided a plurality of mixing means, each mixing means for providing heat transfer medium to one of said plurality of devices, wherein each mixing means: receives first heat transfer medium from a first heat transfer medium source; receives second heat transfer medium from a second heat transfer medium source; and mixes the first and second heat transfer mediums at a proportion dependent on the temperature associated with the respective first device. The first heat transfer medium source may collect heat transfer medium received from at least some of the plurality of devices. The second heat transfer medium source may distribute heat transfer medium from a heat exchanger to at least some of the plurality of devices.

In a third aspect, this specification describes any apparatus configured to perform any method as described with reference to the second aspect.

In a fourth aspect, this specification describes computer-readable instructions which, when executed by computing apparatus, cause the computing apparatus to perform any method as described with reference to the second aspect.

In a fifth aspect, this specification describes a computer program comprising instructions for causing an apparatus to perform at least the following: determine a temperature associated with one or more of a plurality of devices of a base station of a communication system; transfer heat away from one or more devices of the plurality in that are an active state or mode of operation using a heat transfer medium; and transfer at least some of the heat transferred away from the one or more devices of the plurality that are in the active state or mode of operation to one or more devices of the plurality that are in an inactive state or mode of operation using the heat transfer medium.

In a sixth aspect, this specification describes a computer-readable medium (such as a non-transitory computer readable medium) comprising program instructions stored thereon for performing at least the following: determining a temperature associated with one or more of a plurality of devices of a base station of a communication system; transferring heat away from one or more devices of the plurality in that are an active state or mode of operation using a heat transfer medium; and transferring at least some of the heat transferred away from the one or more devices of the plurality that are in the active state or mode of operation to one or more devices of the plurality that are in an inactive state or mode of operation using the heat transfer medium.

In a seventh aspect, this specification describes an apparatus comprising: at least one processor; and at least one memory including computer program code which, when executed by the at least one processor, causes the apparatus to: determine a temperature associated with one or more of a plurality of devices of a base station of a communication system; transfer heat away from one or more devices of the plurality in that are an active state or mode of operation using a heat transfer medium; and transfer at least some of the heat transferred away from the one or more devices of the plurality that are in the active state or mode of operation to one or more devices of the plurality that are in an inactive state or mode of operation using the heat transfer medium.

In an eighth aspect, this specification describes an apparatus comprising: a first control module for determining a temperature associated with one or more of a plurality of devices of a base station of a communication system; a first heat transfer module for transferring heat away from one or more devices of the plurality in that are an active state or mode of operation using a heat transfer medium; and a second heat transfer module (which maybe the same module as the first heat transfer module) for transferring at least some of the heat transferred away from the one or more devices of the plurality that are in the active state or mode of operation to one or more devices of the plurality that are in an inactive state or mode of operation using the heat transfer medium.

### Brief description of the drawings

Example embodiments will now be described, by way of non-limiting examples, with reference to the following schematic drawings, in which:
FIG. 1 is a block diagram of a system in accordance with an example embodiment;
FIG. 2 is a block diagram of a system in accordance with an example embodiment;
FIG. 3 is a flow chart showing an algorithm in accordance with an example embodiment;
FIG. 4 is a block diagram of a system in accordance with an example embodiment;
FIG. 5 is a block diagram of a system in accordance with an example embodiment;
FIG. 6 is a flow chart showing an algorithm in accordance with an example embodiment;
FIG. 7 is a block diagram of a system in accordance with an example embodiment;
FIG. 8 is a block diagram of components of a system in accordance with an example embodiment; and
FIGS. 9A and 9B show tangible media, respectively a removable memory unit and a compact disc (CD) storing computer-readable code which when run by a computer perform operations according to example embodiments.

### Detailed description

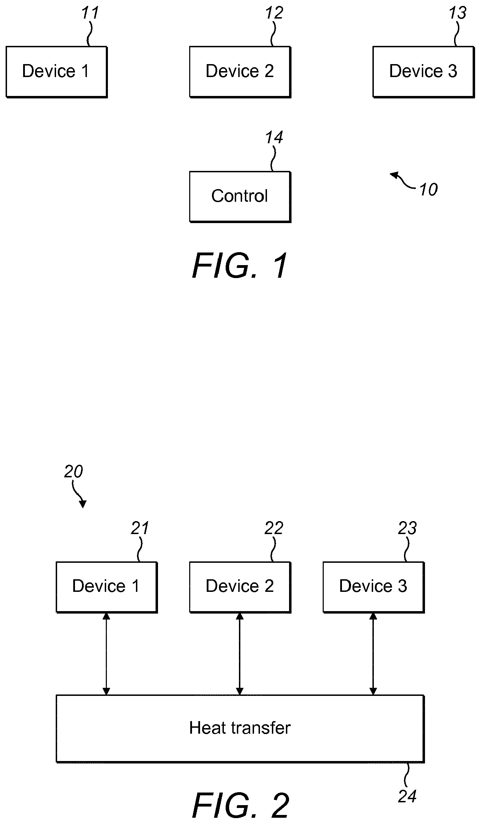

FIG. 1 is a block diagram of a system, indicated generally by the reference numeral 10, in accordance with an example embodiment. The system 10 is a communication system comprising a first device 11, a second device 12, a third device 13 and a control module 14. The plurality of devices may form part of a base station of the communication system. The control module 14 may control one or more of the devices 11 to 13. For example, the control module 14 maybe in communication (e.g. wireless communication) with the first to third devices.

By way of example, one or more of the devices 11 to 13 may be a radio device, such as a remote radio head. Such radio devices typically have a compact design and may reach very high temperatures in operation (i.e. when active), but can also cool to very low temperatures if in a sleep mode, temporarily switched-off or otherwise inactive (particularly when being operated in cold conditions). Allowing the temperature of one of the device 11 to 13 to drop below a dew point may lead to unwanted situations, such as corrosion or short-circuits caused by condensing water. Moreover, allowing significant temperature fluctuations may lead to reduced reliability and reduced device lifetime. Providing a heating arrangement to keep an inactive device at above a desired temperature (e.g. above a dew point) or within a desired temperature range (e.g. to limit temperature cycling) may result in increased energy consumption and related carbon dioxide emissions.

It should be noted that the term "inactive" is generally used here to refer to a device that is not active. An "active" device is in use (or able to be used) and is generally operating in a normal operation range. An "inactive" device could, for example, be in a connected sleep mode, a sleep mode, switch-off or disconnected. "Connected sleep mode" may refer to a device that is partially or totally switched off, but still has connectivity and can be activated by a signal (e.g. a remote signal). A device in a "sleep mode" may be switched off, but able to be re-activated (e.g. after a defined time period or in response to a defined event). A device that is switched off may be in a power off mode (and would need to be switched on in order to become operational). A device that is disconnected may be disconnected from electrical power. The skilled person will be aware of other device arrangements that could be considered to be "active" (e.g. in an active mode or operation) and "inactive" (e.g. in an inactive mode or operation) as those terms as used herein.

At least some of the devices 11 to 13 may be remote radio heads, which may be used, for example, to reduce losses in radio frequency (RF) feeder cables of radio base stations. Remote radio heads may be installed on roofs and antenna masts and can be exposed to a wide range of climate conditions. Many such radio units operate without interruption, such that sufficient heat is generated to prevent a temperature of the radio heads from dropping too low (e.g. below a dew point). At radio sites with multiple frequency layers, one or more modules may be switched to a sleep mode (or some other inactive mode) or even totally switched off for several hours during low-load times. During cold weather, such devices may cool to below the dew point and therefore be vulnerable to corrosion and short-circuiting problems caused by condensed water and/or may be prone to significant temperature cycling. By way of example, some 5G mobile applications provide a range of energy saving solutions, which may result in radio devices being in an inactive (e.g. power saving) mode for an extended period of time. Such energy saving solutions may be ineffective if energy is required to heat such devices (e.g. to maintain a temperature above the dew point or to reduce temperature cycling).

FIG. 2 is a block diagram of a system, indicated generally by the reference numeral 20, in accordance with an example embodiment. System 20 comprises a first device 21, a second device 22 and a third device 23 (similar to the first to third devices 11 to 13 of the system 10 described above). At least some of the devices 21 to 23 may be radio devices (such as remote radio heads), but this is not essential to all embodiments.

The system 20 further comprises a heat transfer module 24, which maybe configured to use a heat transfer medium to transfer heat to and/or from the plurality of devices. The heat transfer medium may, for example, be a liquid such as water (e.g. water incorporating anti-freeze and/or anti-corrosion additives). Other liquids, including alcohols, oils or dielectric liquids could be used. The skilled person will be aware of many suitable heat transfer mediums.

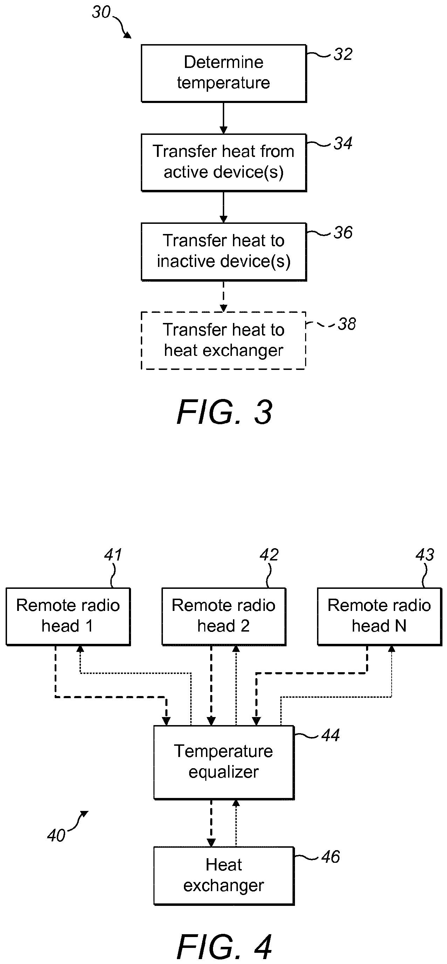

FIG. 3 is a flow chart showing an algorithm, indicated generally by the reference numeral 30, in accordance with an example embodiment. The algorithm 30 maybe implemented by the apparatus 20 described above.

At operation 32 of the algorithm 30, temperature(s) associated with one or more of a plurality of devices (such as one or more of the devices 21 to 23) is/are determined. For illustration purposes, assume that the first device 21 of the system 20 is an inactive state or mode of operation (referred to below as being "inactive" devices), and that the second and third devices 22 and 23 are both in an active state or mode of operation (referred to below as being "active" devices). In conventional systems, the devices may end up having different temperatures depending on their activity. For example, a radio device that is being used for transmission and/or reception of signals may generate heat, whilst a device that is not currently being used (i.e. is not operational or is passive) may not generate such heat.

When the devices are in an active mode, they may produce more waste heat than when in an inactive mode. Assume also that in the system 20, the active devices 22 and 23 are operating at high temperatures (such that cooling is desired) and that the inactive device 21 is operating at a temperature below a desired operational temperature (e.g. below a dew point) or outside (below) a desired temperature range. (The term "dew point" may refer to conditions (typically temperature) below which water begins to condense. Thus, at temperatures below the dew point, water vapour may condense into liquid water.)

At operation 34 of the algorithm 30, heat is transferred away from the active devices using a heat transfer medium. In order to transfer heat away from an active device, a heat transfer medium provided by the heat transfer module 24 to the respective active device(s) is heated by that device and then returned to the heat transfer module 24. Thus, for example, heat transfer medium may be provided by the heat transfer module 24 to the second and third devices 22 and 23 and those active devices used to heat the heat transfer medium.

At operation 36 of the algorithm 30, at least some of the heat transferred away from the active devices is transferred to one or more inactive devices using the heat transfer medium. Thus, for example, the heat transfer medium that has been heated by the active devices 22 and 23 may be used to transfer heat to the inactive device 21. The heat transfer module 24 may control the amount or temperature of heat transfer medium distributed to each of the devices 21 to 23, for example based on a temperature of the respective device.

At optional operation 38 of the algorithm 30, excess heat may be transferred to a heat exchanger (not shown in the system 20). For example, in systems (such as the system 40 described further below) in which a heat exchanger is provided, excess heat can be provided to the heat exchanger. As is known in the art, a heat exchanger is a device that may be used to transfer heat (for example between fluids). Many types of heat exchanges are available, including radiators, heat sinks, plate heat exchanges, phase change heat exchangers etc.

FIG. 4 is a block diagram of a system, indicated by the reference numeral 40, in accordance with an example embodiment. System 40 comprises a first remote radio head 41, a second remote radio head 42, a third remote radio head 43, a temperature equalizing unit 44 and a heat exchanger unit 46. The temperature equalizing unit 44 is similar to the heat transfer unit 24 described above. The temperature equalizer 44 provides heat transfer medium to the remote radio heads 41 to 43 and receives heat transfer medium from the radio devices 41 to 43. The temperature of the heat transfer medium transferred to each of the radio devices 41 to 43 may be controlled by the temperature equalizer 44, as discussed further below. It should be noted that although the system 40 comprises a plurality of remote radio heads, other devices that may require heating and cooling may be provided in addition to, or instead of, some or all of the remote radio heads.

The algorithm 30 described above may be implemented by the apparatus 40.

At operation 32 of the algorithm 30, temperature(s) associated with one or more of a plurality of devices (such as one or more of the remote radio heads 41 to 43) is determined. For illustration purposes, assume that the first remote radio head 41 is an inactive device, and that the second and third remote radio heads 42 and 43 are both active devices (similar to the arrangement discussed above with reference to the system 20).

At operation 34 of the algorithm 30, heat is transferred away from the active devices using a heat transfer medium. In order to transfer heat away from an active device, a heat transfer medium provided by the temperature equalizing unit 44 to the respective active device(s) is heated by that device and then returned to the temperature equalizing unit. Thus, for example, heat transfer medium may be provided to the second and third remote radio heads 42 and 43 and those active devices used to heat the heat transfer medium.

At operation 36 of the algorithm 30, at least some of the heat transferred away from the active devices is transferred to one or more inactive devices using the heat transfer medium. Thus, for example, the heat transfer medium that has been heated by the active devices 42 and 43 maybe used to transfer heat to the inactive device 41.

At operation 38 of the algorithm 30, any excess heat maybe transferred from the temperature equalizing unit 44 to the heat exchanger 46. A control arrangement (e.g. a mechanical and/or electrical valve) maybe provided to control the flow of heat transfer medium to and from the heat exchanger 46. In some embodiments, the heat exchanger 46 may be provided to remove excess heat from the system 40. The use of heated heat transfer material as a heat source for some remote radio heads may reduce the amount of heat dissipated by the heat exchanger 46, thereby potentially reducing energy consumption of the system 40.

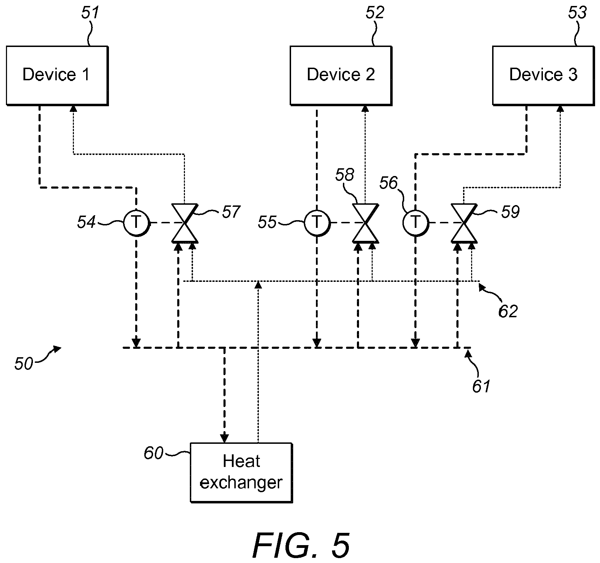

The temperature equalizing unit 44 is used for collecting heat transfer medium received from the remote radio heads 41 to 43 and the heat exchanger 46, and for distributing heat transfer medium to the remote radio heads and also to the heat exchanger 46. In one example embodiment, the heat transfer medium received at the temperature equalizing unit 44 is mixed before being distributed to each of the remote radio heads 41 to 43 (and optionally to the heat exchanger 46). In another example, the temperature equalizer 44 controls the amount or temperature of heat transfer medium distributed to each of the remote radio heads 41 to 43, for example based on a temperature of the respective radio device. An embodiment of such an arrangement is discussed further below, with reference to FIG. 5.

FIG. 5 is a block diagram of a system, indicated generally by the reference numeral 50, in accordance with an example embodiment. System 50 comprises a first, second and third devices 51 to 53 (similar to the devices 21 to 23 and the remote radio heads 41 to 43 described above), first, second and third temperature sensors 54 to 56, first, second and third mixing units 57 to 59, and a heat exchanger unit 60. Temperature sensors 54 to 56 and mixing units 57 to 59 may be comprised within a temperature equalizing unit (and may form at least part of an example implementation of the temperature equalizing unit 44 described above). The heat transfer medium is distributed to each of the devices 51 to 53 via the mixing units 57 to 59 respectively, as described further below.

The first mixing unit 57 receives an input from the first temperature sensor 54, wherein the first temperature sensor indicates a temperature associated with the first device 51. That temperature may, for example, be the temperature of the first device 51 and/or a temperature of a heat transfer medium received from the first device 51. Other temperature measurement options will be apparent to the skilled person (such as the provision of temperature sensors within the devices 51 to 53). Similar arrangements are provided for the second mixing unit 58 which receives an input from the second temperature sensor 55 indicating a temperature associated with the second device 52, and the third mixing unit 59 which receives an input from the third temperature sensor 56 indicating a temperature associated with the third device 53.

The first mixing unit 57 mixes first heat transfer medium obtained from the devices 51 to 53 and second heat transfer medium obtained from the heat exchanger 60. Typically, the first heat transfer medium is relatively hot and the second heat transfer medium is relatively cool. Accordingly, the first mixing unit 57 can provide heat transfer medium to the first device 51 depending on the requirements of the first device 51 (as indicated by the temperature input). Accordingly, if the first device 51 is an active device that needs cooling, then the first mixing unit 58 can provide cool heat transfer medium to the first device 51. Alternatively, if the first device is an inactive device and needs heating, then the first mixing unit 58 can provide hot heat transfer medium to the first device 51. Similar arrangements are provided for the second mixing unit 58 (which receives an input from the second temperature sensor 55 and provides mixed heat transfer medium to the second device 52) and the third mixing unit 59 (which receives an input from the third temperature sensor 56 and provides mixed heat transfer medium to the third device 53).

The functionality of the temperatures sensors 54 to 56 and the associated mixing units 57 to 59 may vary (for example depending on a mode of operation) and may, in some embodiments, be different to one another (for example to set desired temperature ranges differently for different devices 51 to 53). For example, in the event that different sensors are monitoring different types of devices, the requirements for or usage of the temperature sensors may vary.

The first to third mixing units 57 to 59 may be mechanical arrangements with two liquid inputs and a control signal. For example, the mixing units may be valves similar to known valves provided, for example, within shower units. In some embodiments, the first to third mixing units include electronic control systems, for example to monitor and control the temperature of the heat transfer medium being provided to the respective device (i.e. the devices 51 to 53). The skilled person will be aware of many possible implementations of the mixing units 57 to 59.

Many sophisticated temperature control arrangements could be provided. In one example arrangement, the devices 51 to 53 may include internal temperature sensors (as suggested above), such that hot (or cold) spots within the devices may be detectable (and cooling/heating adjustments made) even if the temperature of the relevant heat transfer medium is within a normal range of operation.

Heat transfer medium can be provided to the heat exchanger unit 60, for example from a hot liquid collection arrangement, indicated generally by the reference numeral 61. Similarly, heat transfer medium can be provided from the heat exchanger unit 60, for example to a cold liquid distribution arrangement, indicated generally by the reference numeral 62. A control arrangement (such as a valve) may be provided by the heat exchanger unit 60 and the hot liquid collection arrangement 61 and/or the cold liquid distribution arrangement 62.

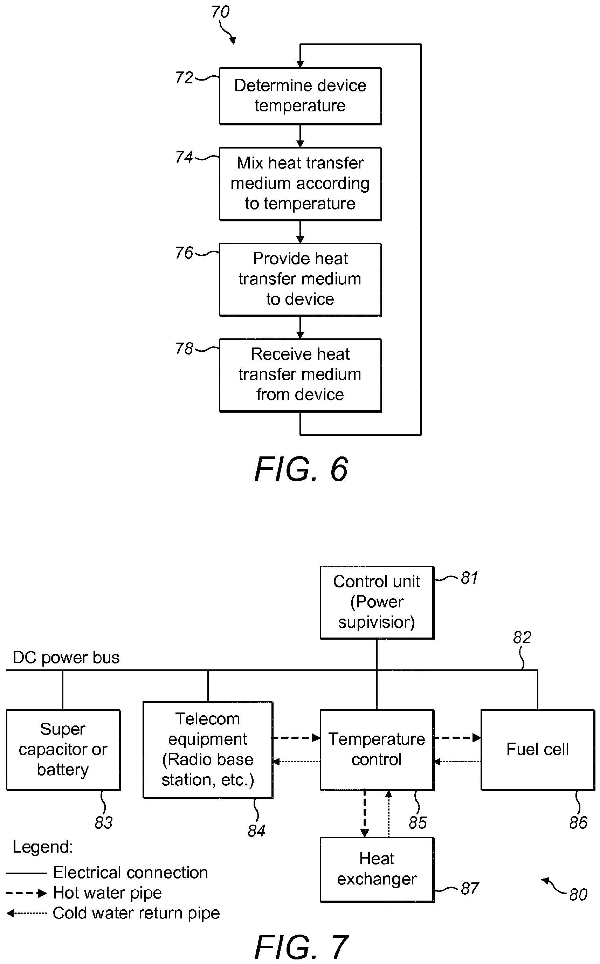

FIG. 6 is a flow chart showing an algorithm, indicated generally by the reference numeral 70, in accordance with an example embodiment. The algorithm 70 may be implemented by a mixing unit of the system 50.

The example below assumes that the algorithm 70 is being implemented by the first mixing unit 57. The algorithm 70 may be implemented in a similar manner by the second and third mixing units 58 and 59.

At operation 72, temperature of one or more of the plurality of devices is determined. For example, the first temperature sensor 54 may be used to determine a temperature associated with first device 51 (such as a temperature of the first device and/or a temperature of a heat transfer medium received from the first device).

At operation 74, the first mixing unit 57 mixes heat transfer medium received from a first source and transfer medium received from a second source depending on the temperature associated with the first device 51 (as indicated by the first temperature sensor 54). The first source maybe the hot liquid collection arrangement 61 and the second source maybe the cold liquid distribution arrangement 62 described above; however, alternative arrangements are possible.

At operation 76, the mixed heat transfer medium is provided to first device 51. At operation 78, heat transfer medium is received (e.g. at the first temperature sensor 54) from the first device. The algorithm then returns to operation 72 and the operations 72 to 78 are repeated.

As indicated above, although the algorithm 70 has been described with reference to the first device 51 and the first mixing unit 57, similar arrangements may be provided for the second device 52 and the second mixing unit 58, and for the third device 53 and the third mixing unit 59.

By way of example, assume that the first device 51 is an inactive device, and that the second and third devices 52 and 53 are active devices. Temperature associated with device 51, determined at temperature sensor 54, is likely to be close to or lower than the threshold value. Temperature associated with devices 52 and 53, determined at temperature sensors 55 and 56 respectively, is likely to be higher than (perhaps significantly higher than) a threshold value. Mixing unit 57 receives the information of the temperature from temperature sensor 54, and mixes the heat transfer medium based on the information, such that the heat transfer medium provided to device 51 allows the temperature of device 51 to be maintained above the threshold value or within a defined temperature range. This may require the proportion of cold heat transfer medium received from the heat exchanger to be lower than the proportion of hot heat transfer medium received from active devices, such as devices 52 and 53. Alternatively, for devices 52 and 53, the temperature maybe required to be lower in order to prevent over-heating. As such, mixing units 58 and 59 may mix higher proportions of cold heat transfer medium from the heat exchanger, and lower proportions of hot heat transfer medium from active devices 52 and 53. It can be seen that the arrangement of mixing units and means of transferring heat transfer medium is such that the mixing configuration maybe changed based on changes in the activity status of the devices 51 to 53.

In one example embodiment, the mixing units 57 to 59 are configured to receive first heat transfer medium from a first heat transfer medium source and a second heat transfer medium from a second heat transfer medium source. The first heat transfer medium source may, for example, be a liquid collector, collecting heat transfer medium received from at least some of the devices 51 to 53. The first heat transfer medium may have high temperature (e.g. hot liquid), as it may include heat transfer medium collected from active devices. The second heat transfer medium source may, for example, be a liquid distributor, that distributes heat transfer medium from heat exchanger 60 to at least some of the devices 51 to 53. The second heat transfer medium may have low temperature (e.g. cold liquid). The mixing units 57 to 59 then mix the first and second heat transfer medium at a proportion dependent on the temperature associated with the devices 51 to 53 respectively.

In many of the examples described above, the devices (such as the devices 21 to 23, 41 to 43 and 51 to 53) are radio devices (such as remote radio heads). This is not essential to all embodiments. For example, as described below, other devices (such as a fuel cell) may be heated or cooled by the principles described herein. Moreover, said devices may include some radio devices and some other devices.

FIG. 7 is a block diagram of a system, indicated generally by the reference numeral 80, in accordance with an example embodiment. The system 80 could, for example, be used as part of a telecommunications site (e.g. a base station) including an electrical power back-up system.

As shown in FIG. 7, the system 80 comprises a control unit 81, a DC power bus 82, a super capacitor or battery 83, telecommunications equipment 84 (which may include some of the devices 41 to 43 and 51 to 53 described above), a temperature control module 85, a fuel cell 86 and a heat exchanger 87.

In one example use of the system 80, DC power is provided from an external power source to the DC power bus 82, which DC power is used to power the telecommunication equipment 84 and to charge the super capacitor or battery 83. In the event of a power failure, the super capacitor or battery 83 provides DC power to the DC power bus 82 for a short period of time before the fuel cell 86 provides DC power.

The fuel cell 86 may be required to provide DC power relatively quickly in the event of a failure of the external power supply. In order to do so, the fuel cell may need to be kept at (or near) an operational temperature, which may be quite high (e.g. of the order of 80 degrees centigrade). In the event that the fuel cell is at a lower temperature (e.g. at a normal room temperature), it may take as long as 10 to 15 minutes for the fuel cell to be heated to an operational temperature, which may severely limit practical applications of the system 80.

The temperature control module 85 may provide a heat transfer medium to the telecommunications equipment 84 in order to transfer heat away from active devices of the telecommunications equipment (such as remote radio heads or other radio devices). At least some of the heat transferred away from the telecommunications equipment 84 maybe transferred (by the temperature control module 85) to the fuel cell 86 in order to heat the fuel cell. In this way, the fuel cell 86 can be maintained at or near an operating temperature (for example within a defined temperature range), thereby consuming heat extracted from the telecommunication equipment, which heat may otherwise have been dissipated by the heat exchanger 87.

Of course, many variants to the system 80 are possible. For example, the super capacitor or battery 83 may be omitted (such that the fuel cell 86 provides DC power in the event of a failure of an external power supply, without the provision of a super capacitor or battery).

In some example embodiments, one of the purposes of transferring heat away from first (e.g. active) devices to second (e.g. inactive) devices is to maintain temperature of the inactive devices above a threshold temperature or within a temperature range. At radio sites with multiple frequency layers, such as the base station comprising the communication system described above, one or more modules might be switched into sleep mode or be switched off for several hours during low load times. This could cause devices installed at exposed locations to cool below a threshold temperature (for example, the dew point). To avoid corrosion caused by condensed water, the temperature of the devices may be maintained above the threshold value. As the active devices are prevented from overheating, the excess heat is utilized to maintain temperature of the inactive devices above the threshold value (rather than discarding/ disposing the excess heat. Keeping the system temperature variation as minimal as possible, for example above a pre-determined minimum temperature threshold and below a pre-determined maximum temperature threshold, may decrease system failures and increase system reliability and lifetime.

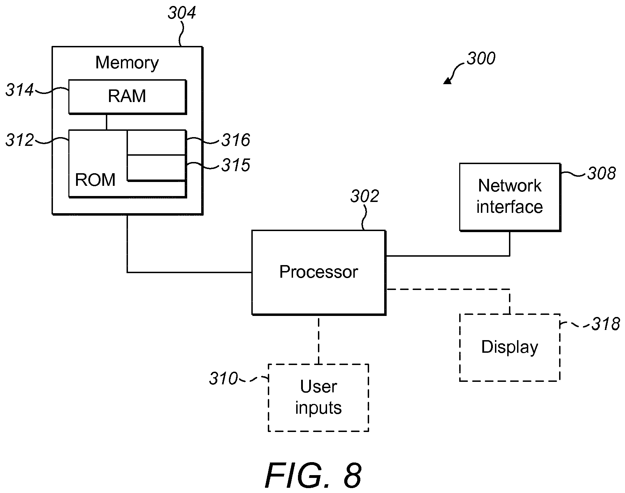

For completeness, FIG. 8 is a schematic diagram of components of one or more of the example embodiments described previously, which hereafter are referred to generically as processing systems 300. A processing system 300 may comprise a processor 302, a memory 304 coupled to the processor and comprised of a RAM 314 and ROM 312, and user input 310 and a display 318. The processing system 300 may comprise one or more network/apparatus interfaces 308 for connection to a network/apparatus, e.g. a modem which maybe wired or wireless. Interface 308 may also operate as a connection to other apparatus such as device/apparatus which is not network side apparatus. Thus direct connection between devices/ apparatus without network participation is possible.

The processor 302 is connected to each of the other components in order to control operation thereof.

The memory 304 may comprise a non-volatile memory, such as a hard disk drive (HDD) or a solid state drive (SSD). The ROM 312 of the memory 314 stores, amongst other things, an operating system 315 and may store software applications 316. The RAM 314 of the memory 304 is used by the processor 302 for the temporary storage of data. The operating system 315 may contain code which, when executed by the processor implements aspects of the algorithms 30 and 70 described above. Note that in the case of small device/ apparatus the memory can be most suitable for small size usage i.e. not always hard disk drive (HDD) or solid state drive (SSD) is used.

The processor 302 may take any suitable form. For instance, it may be a microcontroller, a plurality of microcontrollers, a processor, or a plurality of processors.

The processing system 300 may be a standalone computer, a server, a console, or a network thereof. The processing system 300 and needed structural parts may be all inside device/ apparatus such as IoT device/ apparatus i.e. embedded to very small size

In some example embodiments, the processing system 300 may also be associated with external software applications. These may be applications stored on a remote server device/ apparatus and may run partly or exclusively on the remote server device/apparatus. These applications maybe termed cloud-hosted applications. The processing system 300 may be in communication with the remote server device/ apparatus in order to utilize the software application stored there. By way of example, some embodiments may incorporate remote supervision (e.g. remote supervision of temperature(s) in the system).

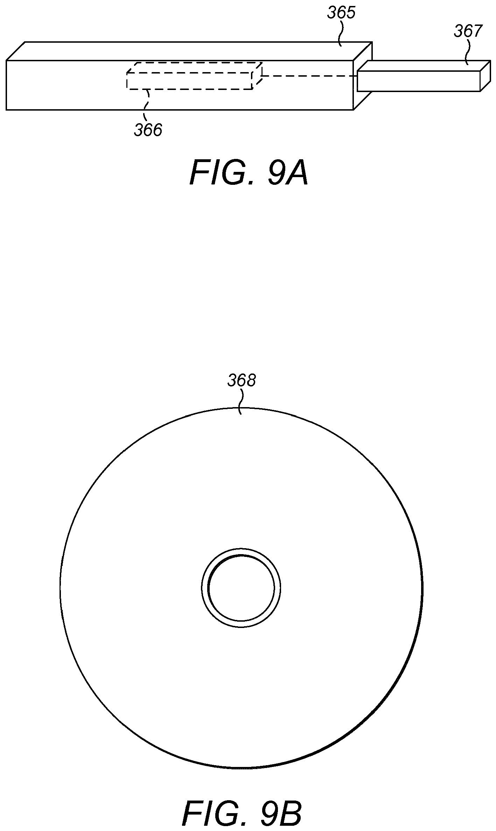

FIGs. 9A and 9B show tangible media, respectively a removable memory unit 365 and a compact disc (CD) 368, storing computer-readable code which when run by a computer may perform methods according to example embodiments described above. The removable memory unit 365 may be a memory stick, e.g. a USB memory stick, having internal memory 366 storing the computer-readable code. The memory 366 may be accessed by a computer system via a connector 367. The CD 368 may be a CD-ROM or a DVD or similar. Other forms of tangible storage media may be used. Tangible media can be any device/ apparatus capable of storing data/information which data/information can be exchanged between devices/apparatus/network.

Embodiments of the present invention may be implemented in software, hardware, application logic or a combination of software, hardware and application logic. The software, application logic and/or hardware may reside on memory, or any computer media. In an example embodiment, the application logic, software or an instruction set is maintained on any one of various conventional computer-readable media. In the context of this document, a "memory" or "computer-readable medium" may be any non-transitory media or means that can contain, store, communicate, propagate or transport the instructions for use by or in connection with an instruction execution system, apparatus, or device, such as a computer.

Reference to, where relevant, "computer-readable storage medium", "computer program product", "tangibly embodied computer program" etc., or a "processor" or "processing circuitry" etc. should be understood to encompass not only computers having differing architectures such as single/ multi-processor architectures and sequencers/parallel architectures, but also specialised circuits such as field programmable gate arrays FPGA, application specify circuits ASIC, signal processing devices/ apparatus and other devices/ apparatus. References to computer program, instructions, code etc. should be understood to express software for a programmable processor firmware such as the programmable content of a hardware device/ apparatus as instructions for a processor or configured or configuration settings for a fixed function device/ apparatus, gate array, programmable logic device/ apparatus, etc.

As used in this application, the term "circuitry" refers to all of the following: (a) hardware-only circuit implementations (such as implementations in only analogue and/or digital circuitry) and (b) to combinations of circuits and software (and/or firmware), such as (as applicable): (i) to a combination of processor(s) or (ii) to portions of processor(s)/ software (including digital signal processor(s)), software, and memory(ies) that work together to cause an apparatus, such as a server, to perform various functions) and (c) to circuits, such as a microprocessor(s) or a portion of a microprocessor(s), that require software or firmware for operation, even if the software or firmware is not physically present.

If desired, the different functions discussed herein maybe performed in a different order and/or concurrently with each other. Furthermore, if desired, one or more of the above-described functions may be optional or may be combined. Similarly, it will also be appreciated that the flow diagrams of FIGs. 3 and 6 are examples only and that various operations depicted therein maybe omitted, reordered and/or combined.

It will be appreciated that the above described example embodiments are purely illustrative and are not limiting on the scope of the invention. Other variations and modifications will be apparent to persons skilled in the art upon reading the present specification.

Moreover, the disclosure of the present application should be understood to include any novel features or any novel combination of features either explicitly or implicitly disclosed herein or any generalization thereof and during the prosecution of the present application or of any application derived therefrom, new claims may be formulated to cover any such features and/or combination of such features.

Although various aspects of the invention are set out in the independent claims, other aspects of the invention comprise other combinations of features from the described example embodiments and/or the dependent claims with the features of the independent claims, and not solely the combinations explicitly set out in the claims.

It is also noted herein that while the above describes various examples, these descriptions should not be viewed in a limiting sense. Rather, there are several variations and modifications which may be made without departing from the scope of the present invention as defined in the appended claims.

## Claims

1. An apparatus comprising:
means for determining a temperature associated with one or more of a plurality of devices of a base station of a communication system;
means for transferring heat away from one or more devices of the plurality that are in an active state or mode of operation using a heat transfer medium; and
means for transferring at least some of the heat transferred away from the one or more devices of the plurality that are in the active state or mode of operation to one or more devices of the plurality that are in an inactive state or mode of operation using the heat transfer medium.

2. An apparatus as claimed in claim 1, wherein one or more of said devices are telecommunication devices.

3. An apparatus as claimed in claim 1 or claim 2, wherein one or more of said devices are fuel cells.

4. An apparatus as claimed in any one of the preceding claims, wherein the temperature associated with the one or more of the plurality of devices is a temperature of the one or more of the plurality of devices respectively.

5. An apparatus as claimed in any one of the preceding claims, wherein the temperature associated with the one or more of the plurality of devices is a temperature of the heat transfer medium received from the one or more of the plurality of devices respectively.

6. An apparatus as claimed in any one of the preceding claims, further comprising means for maintaining a temperature of one or more of said one or more devices above a threshold value.

7. An apparatus as claimed in any one of the preceding claims, further comprising means for maintaining a temperature of one or more of said one or more devices within a defined temperature range.

8. An apparatus as claimed in any one of the preceding claims, further comprising:
means for mixing heat transfer medium received from the one or more devices of the plurality that are in the active state or mode of operation; and
means for distributing the mixed heat transfer medium to the one or more devices of the plurality that are in the inactive state or mode of operation.

9. An apparatus as claimed in any one of the preceding claims, further comprising:
means for mixing heat transfer medium received from one or more devices of the plurality that are in the active state or mode of operation and heat transfer medium received from one or more devices of the plurality that are in the inactive state or mode of operation; and
means for distributing the mixed heat transfer medium to the one or more devices of the plurality that are in the inactive state or mode of operation.

10. An apparatus as claimed in any one of the preceding claims, further comprising a plurality of mixing means, each mixing means for providing heat transfer medium to one of said plurality of devices, wherein each mixing means comprises:
means for receiving first heat transfer medium from a first heat transfer medium source;
means for receiving second heat transfer medium from a second heat transfer medium source; and
means for mixing the first and second heat transfer mediums at a proportion dependent on the temperature associated with the respective first device.

11. An apparatus as claimed in claim 10, wherein the first heat transfer medium source collects heat transfer medium received from at least some of the plurality of devices.

12. An apparatus as claimed in claim 10 or claim 11, wherein the second heat transfer medium source distributes heat transfer medium from a heat exchanger to at least some of the plurality of devices.

13. An apparatus as claimed in any one of the preceding claims, wherein the means comprise:
at least one processor; and
at least one memory including computer program code, the at least one memory and the computer program configured, with the at least one processor, to cause the performance of the apparatus.

14. A method comprising:
determining a temperature associated with one or more of a plurality of devices of a base station of a communication system;
transferring heat away from one or more devices of the plurality that are in an active state or mode of operation using a heat transfer medium; and
transferring at least some of the heat transferred away from the one or more devices of the plurality that are in the active state or mode of operation to one or more devices of the plurality that are in an inactive state or mode of operation using the heat transfer medium.

15. A computer readable medium comprising program instructions stored thereon for performing at least the following:
determining a temperature associated with one or more of a plurality of devices of a base station of a communication system;
transferring heat away from one or more devices of the plurality in that are an active state or mode of operation using a heat transfer medium; and
transferring at least some of the heat transferred away from the one or more devices of the plurality that are in the active state or mode of operation to one or more devices of the plurality that are in an inactive state or mode of operation using the heat transfer medium.
